# EUROPEAN PATENT APPLICATION

(11) **EP 4 246 573 A2**
(43) Date of publication of application: **20.09.2023**
(21) Application number: 23161516.2
(22) Date of filing: 13.03.2023
(51) Int. Cl.: H01L 23/538, H01L 23/552

(54) **FLIP CHIP DEVICE THROUGH PACKAGE VIA PLACEMENT**

(30) Priority: 14.03.2022 US 202217694330
(71) Applicant: NXP B.V., 5656 AG Eindhoven (NL)
(72) Inventor: Kamphuis, Antonius Hendrikus Jozef, 5656AG Eindhoven (NL); Acar, Mustafa, 5656AG Eindhoven (NL); Freidl, Philipp Franz, 5655AG Eindhoven (NL); Mandamparambil, Rajesh, 5656AG Eindhoven (NL); Bergman, Jan Willem, 5656AG Eindhoven (NL)
(74) Representative: Miles, John Richard

(57) **Abstract**

A flip chip device includes a substrate, an integrated circuit device, a mold compound, and a via. The substrate has a top side and a bottom side. The integrated circuit device is affixed to the bottom side of the substrate. The mold compound is affixed to the bottom side of the substrate. The via is affixed to the bottom side of the substrate. The via passes through the mold compound and is exposed at a bottom side of the mold compound. The via is coupled to a terminal of the integrated circuit device.

## Description

### Field of the Disclosure

This disclosure generally relates to the fabrication of semiconductor devices, and more particularly relates to flip-chip device through package via placement.

### BACKGROUND

Flip chip devices provide a popular and efficient method for packaging integrated circuit (IC) devices for assembly into larger electronic systems. Typically, one or more IC devices are assembled onto a package substrate and encapsulated. In some flip chip devices, it may be desirable to provide shielding for various signals. However, such shielding structures may impact the encapsulation process of the IC device. It would therefore be advantageous to provide flip chip devices in a manner that accommodates shielding structures without impacting the encapsulation process of the IC device.

### BRIEF DESCRIPTION OF THE DRAWINGS

It will be appreciated that for simplicity and clarity of illustration, elements illustrated in the Figures have not necessarily been drawn with accurate shapes or to scale. For example, the dimensions of some of the elements are exaggerated relative to other elements. Embodiments incorporating teachings of the present disclosure are shown and described with respect to the drawings presented herein, in which:
FIG. 1 illustrates a flip chip device in accordance with an embodiment of the current disclosure; and
FIGs. 2-9 illustrate a method for fabricating the flip chip device of FIG. 1.

The use of the same reference symbols in different drawings indicates similar or identical items.

### DETAILED DESCRIPTION OF DRAWINGS

The following description in combination with the Figures is provided to assist in understanding the teachings disclosed herein. The description will focus on specific implementations and embodiments of the teachings. This focus is provided to assist in describing the teachings, and should not be interpreted as a limitation on the scope or applicability of the teachings. Moreover, other teachings can be used in association with the teachings of this application, as needed or desired, without limiting the scope of the teachings herein.

In an embodiment of the current disclosure, a flip chip device may include a substrate, an IC device, a mold compound, and a via. The substrate may have a top side and a bottom side. The IC device may be affixed to the bottom side of the substrate. The mold compound may be applied to the bottom side of the substrate. The via may be affixed to the bottom side of the substrate. The via may pass through the mold compound and is exposed at a bottom side of the mold compound. The via is coupled to a terminal of the IC device.

In another embodiment of the current disclosure, a method of fabricating a flip chip device is given. The method may include attaching an IC device to a bottom side of a substrate of the flip chip device, forming a via on the bottom side of the substrate, and applying a mold compound to the bottom side of the substrate. The via may pass through the mold compound and is exposed at a bottom side of the mold compound. The via may be coupled to a terminal of the IC device. In one or more embodiments, the method may further comprise: prior to applying the mold compound, forming, on the bottom side of the substrate, a second, wherein the second via passes through the mold compound and is exposed at the bottom side of the mold compound, and wherein the second via is coupled to a second terminal of the integrated circuit device.

In one or more embodiments, the first via may be configured for carrying a radio frequency signal of the integrated circuit device. In one or more embodiments, the second terminal is a shield terminal of the integrated circuit device. In one or more embodiments, the second via may forms a coaxial shield around the first via. In one or more embodiments, the method may further comprise: attaching, to the first via, a first solder ball, wherein the first solder ball is attached to the first via at the bottom side of the mold compound.

In one or more embodiments, the method may further comprise: attaching, to a bottom side of the integrated circuit device, a second solder ball. In one or more embodiments, the second solder ball may provide a ground terminal for the integrated circuit device. In one or more embodiments, the second solder ball may provide a thermal terminal for the integrated circuit device.

In yet another embodiment of the current disclosure, a flip chip device may include a substrate, a first IC device, a second IC device, a mold compound, a first via, and a second via. The substrate may have a top side and a bottom side. The first IC device may be affixed to the bottom side of the substrate. The second IC device may be affixed to the bottom side of the substrate. A first terminal of the first IC device may be coupled to a first terminal of the second IC device. The mold compound may be applied to the bottom side of the substrate. The first via may be affixed to the bottom side of the substrate. The first via may pass through the mold compound and may be exposed at a bottom side of the mold compound. The first via may be coupled to a second terminal of the first IC device. The second via may be affixed to the bottom side of the substrate. The second via may pass through the mold compound and may be exposed at the bottom side of the mold compound. The second via may be coupled to a second terminal of the second IC device.

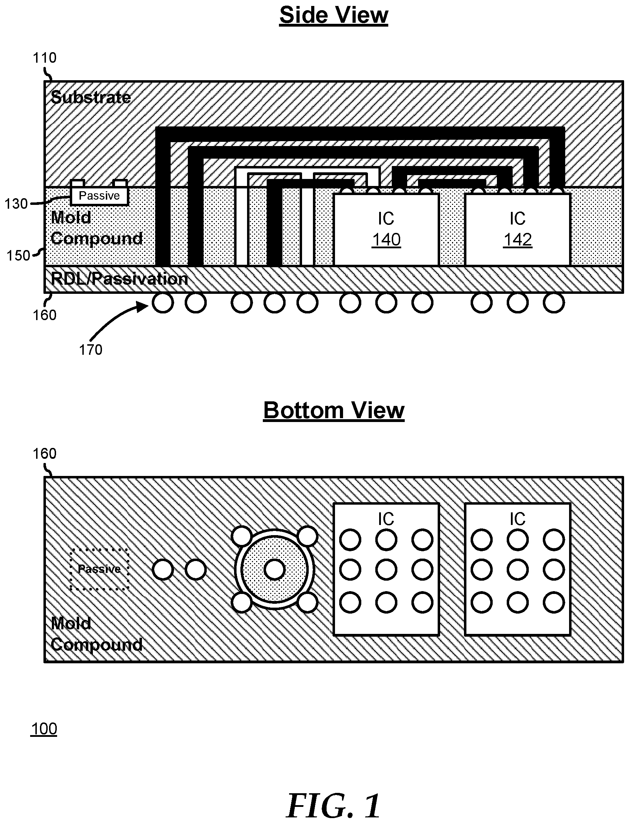

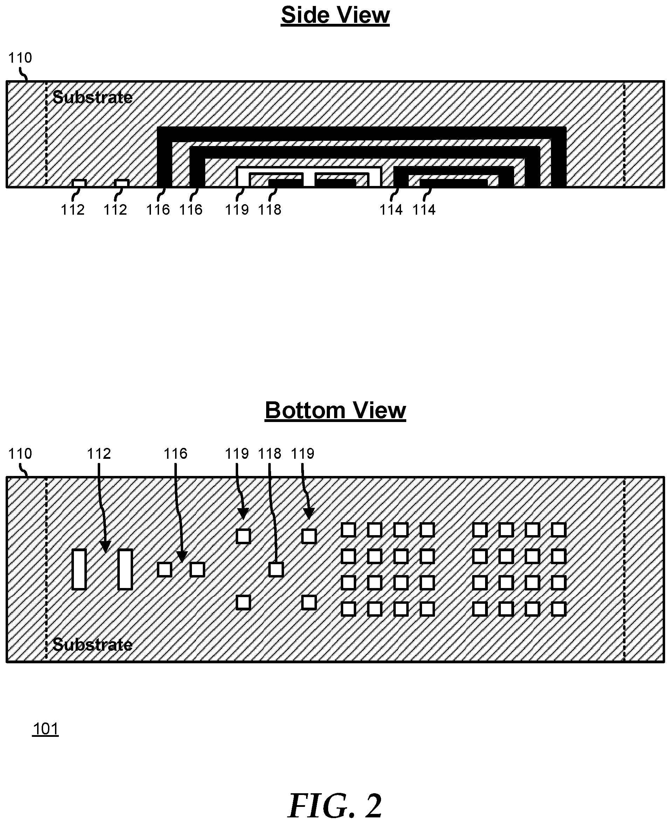

FIG. 1 illustrates a flip chip device 100. Flip chip device 100 is a device for packaging a pair of IC devices for assembly to an electronic system, for example by mounting the flip chip device to a PCB. Flip chip device 100 includes a substrate 100 that provides power, ground, and signal routing from the associated PCB to one or more passive device 130 and a pair of IC devices 140 and 142, and between the passive device and the IC devices as needed or desired. In a particular embodiment, substrate 110 represents a laminate structure with power, ground, and signal traces routed through various layers of the laminate structure that are interconnected with conductive vias between the layers. In another embodiment, substrate 110 represents a solid structure with power, ground, and signal traces fabricated on the bottom surface of the structure utilizing, for example a redistribution layer (RDL)/passivation layer fabrication process. The construction and fabrication of flip chip substrates and power, ground, and signal trace routing therein is known in the art and will not be further described herein, except as needed to illustrate the current embodiments. Other details of flip chip device 100, illustrated here, but not specifically enumerated or described, will be described below in the context of the method for fabricating the flip chip device, as shown and described in FIGs. 2-9.

Flip chip device 100 is characterized by the fact that IC devices 140 and 142 are affixed to a bottom side of substrate 110, that a mold compound 150 is applied to the bottom side of the substrate, and the power, ground, and signal contacts are provided by vias 126, 128, and 129 to a bottom side of the mold compound. The power, ground, and signal traces are provided with solder bumps 170 to finish the flip chip packaging of flip chip device 100. In this regard, substrate 110 does not necessarily route power, ground, and signal traces to a top side of the substrate. The construction and fabrication of flip chip substrates and power, ground, and signal trace routing therein is known in the art and will not be further described herein, except as needed to illustrate the current embodiments. More detailed descriptions of the elements of flip chip device 100 will be provided in the method described below.

As illustrated, flip chip device 100 represents a device that provides a RF functionality, where IC device 140 may represent a RF IC device that has a RF input/output, and that provides pre-processed signals to IC device 142, and where IC device 142 may represent an interface IC device that provides various signal processing functions on the RF signals received from IC device 140. Here, IC device 140 is connected to traces of substrate 110 that are routed to a coaxially shielded RF input/output, as described below.

FIGs. 2-9 illustrate a method for fabricating flip chip device 100. In a first step 101, illustrated in FIG. 2, substrate 110 is provided. Substrate 110 is illustrated as extending beyond the confines of flip chip device 100. Here it will be understood that flip chip device 100 may be fabricated as one of one or more additional flip chip devices (not illustrated) that are next to flip chip device 110, and that a final process step may include separating flip chip device 110 from the other flip chip devices as needed or desired. Substrate 110 includes passive device pads 112 with associated traces (not illustrated), IC-to-IC pads 114 with traces between the circuit elements of the IC devices, external signal pads 116 (here illustrated as coming from IC device 142), and a RF input/output pad 118 and associated coaxial shield pads 119 (here illustrated as coming from IC device 140. It will be understood that flip chip device 100 may include one or more additional IC devices, as needed or desired, or may include only one IC device as needed or desired. Further, flip chip device 100 need not represent a device that provides RF functionality, but may represent other types of devices as needed or desired. Note that in the bottom view of step 101, the pads for IC device 140 and IC device 142 are not separately delineated. Here it will be understood that one or more of the illustrated pads may be associated with IC-to-IC signals, with external signals, with power and ground contacts, or the like, as needed or desired. Note that the features in the current illustrations may not be deemed to be to scale, and a greater or a lesser number of pads may be provided in a substrate as needed or desired.

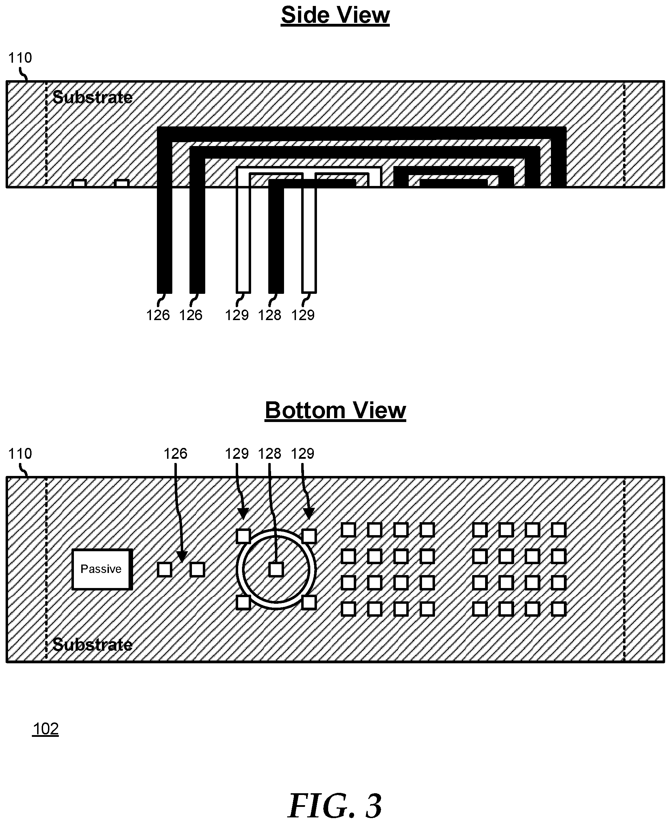

In a next step 102, illustrated in FIG. 3, vias are added to all of the pads on the bottom of substrate 110 that are associated with external connections, including power connections, ground connections, and signal connections. Here, external signal vias 126, RF input/output vias 128, and coaxial shield vias 129 are added to respective external signal pads 116, RF input/output vias 118, and coaxial shield pads 119. For simplicity, any power connections and ground connections are not illustrated. Coaxial shield via 129, as illustrated, shows a complex structure where the four coaxial shiel pads 119 are interconnected with a coaxial shied around RF input/output via 118. In this way, the passage of RF signals from an RF input/output on the associated PCB are shielded. Note that no vias are needed in association with passive device pads 112 and IC-to-IC pads 114, as these pads are not needed to be routed to the exterior (the bottom side) of flip chip device 100. It will be understood that in step 102 other structures may be added to the bottom of substrate 110, as needed or desired. For example, other types of shielding structures, thermally conductive fin structures, or other elements may be added to the bottom of substrate 110, as needed of desired. External signal vias 126, RF input/output vias 128, coaxial shield vias 129, and any other structures added to the bottom of substrate 110 can be provided by any process for adding material to a substrate as may be known in the art, including, but not limited to photolithographic processes, additive manufacturing processes, bonding processes, welding processes, or the like.

As illustrated in FIG. 2, substrate 110 represents a laminate structure with power, ground, and signal traces routed through various layers of the laminate structure that are interconnected with conductive vias between the layers. Substrate 110 may further represent a solid structure with power, ground, and signal traces fabricated on the bottom surface of the structure utilizing a RDL/passivation layer fabrication process. Substrate 110 may further represent a combination of a laminate structure and features formed on the laminate structure by a RDL/passivation layer fabrication process. The construction and fabrication of flip chip substrates and power, ground, and signal trace routing therein is known in the art and will not be further described herein, except as needed to illustrate the current embodiments. In any case, it will be understood that, due to the routing of signals through traces or RDL layers, a particular IC device may have a footprint that extends beyond internal trace/vias or RDL layers, as needed or desired. Note that after the completion of step 102, substrate 110 may be considered to be a completed manufactured item. For example, while the method steps shown in FIGs. 2-9 show the substrate material extending beyond the edge of flip chip device 100, thereby illustrating a particular type of batch manufacturing of flip chip devices, it may be understood that substrates similar to substrate 110 may be separated after the processing shown in step 102, and further processing as described below may be performed on individual substrates as needed or desired.

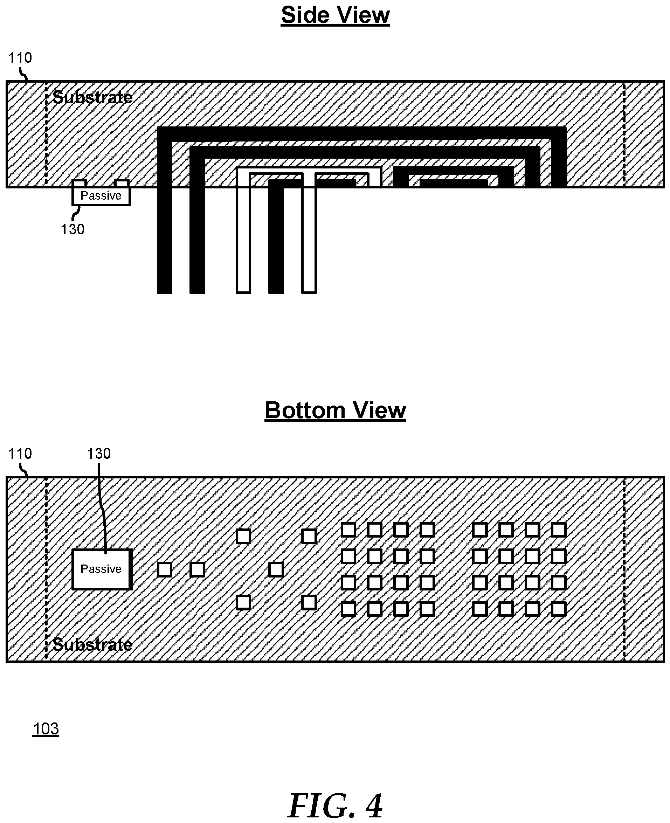

In a next step 103, illustrated in FIG. 4, a passive device 130 is affixed to the bottom side of substrate 110 at passive device pads 112. Here, passive device 130 represents a device that acts to control the electrical properties of a circuit without an external control signal, and may include a capacitor, a resistor, an inductor, a transformer, an array of capacitors, resistors, inductors or the like, or other types of circuit elements as needed or desired. One or more additional passive devices may be affixed to substrate 100 as needed or desired. As illustrated, passive device 130 is affixed to a same bottom surface of substrate 100 as IC devices 140 and 142, but this is not necessarily so, and passive devices may be affixed to a top surface of the substrate as needed or desired.

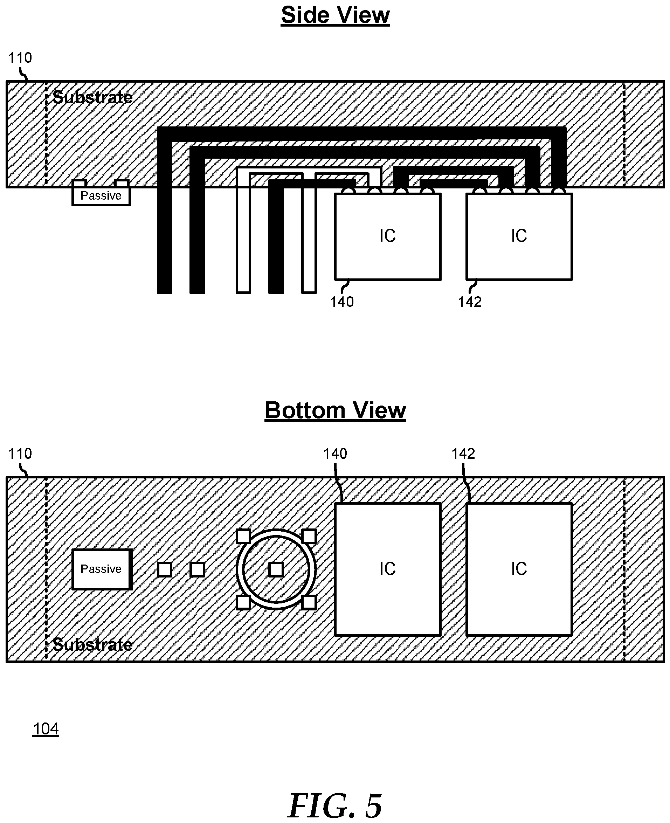

In a next step 104, illustrated in FIG. 5, IC device 140 and IC device 142 are affixed by their active sides to the bottom side of substrate 110. Here, affixing IC devices to a flip chip substrate is known in the art and will not be further described herein except as needed to illustrate the current embodiments. Further, it will be understood that affixing passive device 130 as described in step 103, and affixing IC device 140 and IC device 142 to the bottom side of substrate 110 as described herein may be performed as a single assembly step, such as where a surface mount/solder reflow process is utilized to affix components to the substrate.

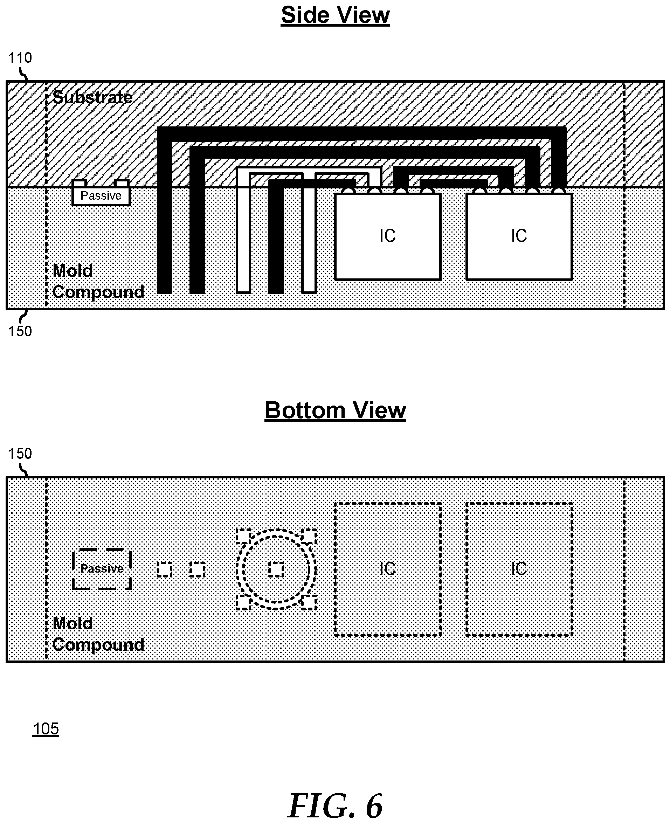

In a next step 105, illustrated in FIG. 6, mold compound 150 is applied to the bottom side of substrate 110. Here, any molding process may be utilized as may be known in the art, such as barrier fill molding, injection molding, or the like, and any curing process may be utilized as may be known in the art, such as air/heat curing, UV curing, or the like. It will be here understood that the mold process of step 105 will operate to flow mold compound 150 into the gap between substrate 110 and IC device 140 and IC device 142. In particular, because CUF is not needed to flow mold compound 150 into the gap between substrate 110 and IC device 140 and IC device 142, the spacing between the coaxial structure formed by RF input/output vias 128 and coaxial shield vias 129 may be placed closer to IC device 140 than would otherwise be permitted if CUF methods were utilized. In this way, the RF performance of flip chip device 100 may be improved. Note that, as illustrated, external signal vias 126, RF input/output via 128, and coaxial shield vias 129 are higher than the height of IC device 140 and IC device 142, but this is not necessarily so, as shall be described in step 106 below. Here, external signal vias 126, RF input/output via 128, and coaxial shield vias 129 may be lower than IC device 140 and IC device 142, or may be the same height as the IC devices, as needed or desired. Further note that, as illustrated, mold compound 150 is shown to be filled to a height that is higher than any of external signal vias 126, RF input/output via 128, coaxial shield vias 129, IC device 140, and IC device 142, but this is not necessarily so, as shall be described in step 106 below. Here, the height of mold compound 150 may be the same height as any of external signal vias 126, RF input/output via 128, coaxial shield vias 129, IC device 140, or IC device 142, or may be lower still, as needed or desired.

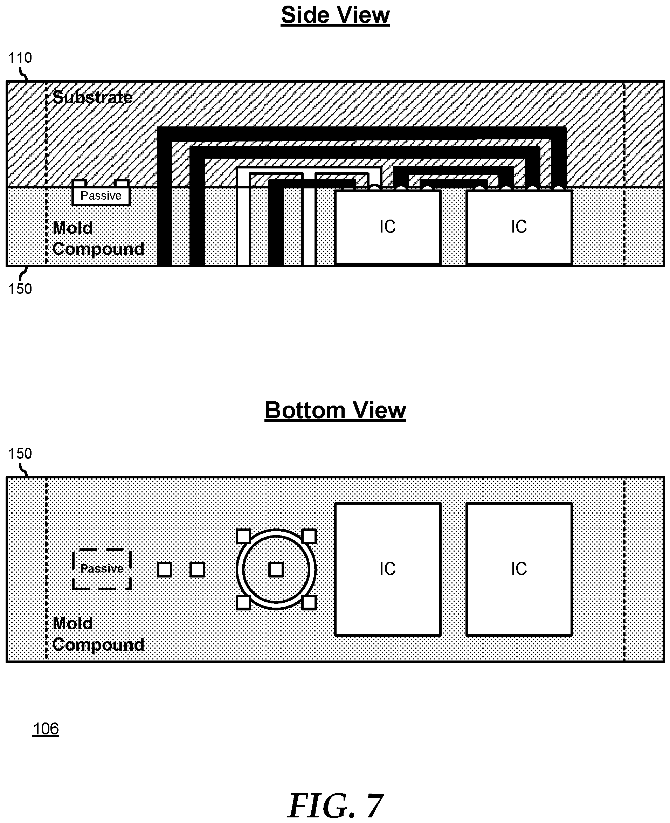

In a next step 106, illustrated in FIG. 7, mold compound 150 is ground down such that external signal vias 126, RF input/output via 128, coaxial shield vias 129, IC device 140, IC device 142, and the mold compound are at a common height. Here, it will be understood that mold compound 150 should be ground to a height that exposes external signal vias 126, RF input/output via 128, and coaxial shield vias 129. However, the bottom sides of IC device 140 and IC device 142 may be exposed by the grinding process of step 106, or may not be exposed by the grinding process, as needed or desired. Further, IC device 140 and IC device 142 may be thinned in the grinding process of step 106, as needed or desired. However, note that, when the back sides of IC device 140 and IC device 142 are exposed by the grinding process, the exposed back sides of the IC devices may be utilized for providing ground contacts for the IC devices, and for providing thermal conduction of heat from the IC devices, as described in 107 below.

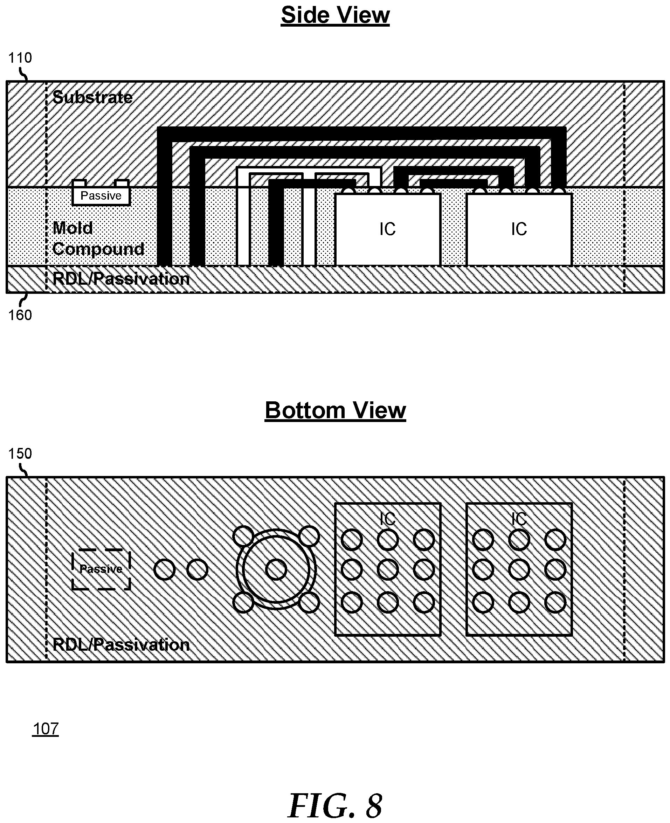

In a next step 107, illustrated in FIG. 8, RDL layers and passivation 160 are formed on mold compound 150. Here, the exposed ends of external vias 126, RF input/output vias 128, and coaxial shield vias 129 are rerouted as needed or desired to contact pads on the bottom side of RDL/passivation 160. Here, RDL/passivation 160 may be provided by any process as may be known in the art for forming RDL and passivation for IC devices, as needed or desired.

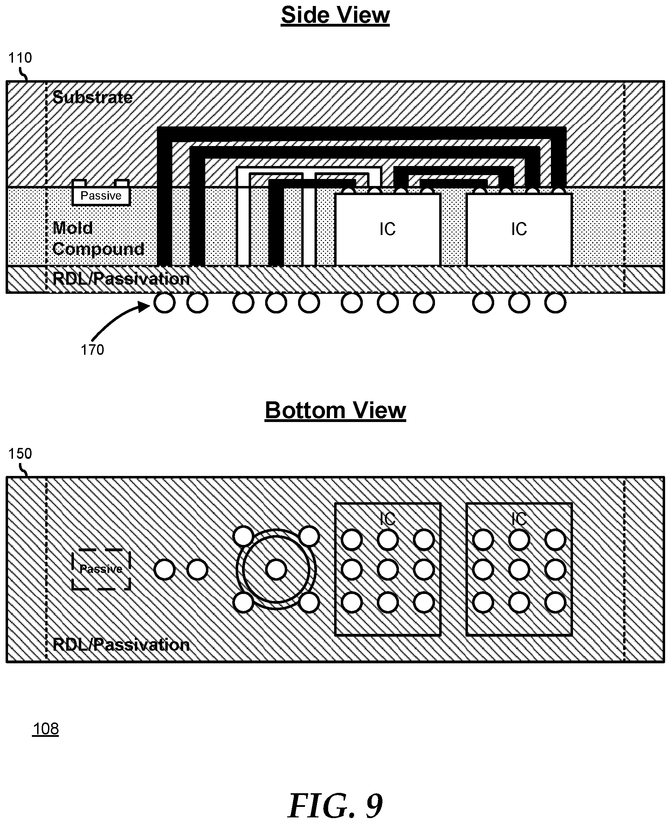

In a next step 108, illustrated in FIG. 9, solder balls 170 are attached to contact pads on the bottom of RDL/passivation 160, and to the back sides of IC device 140, and IC device 142 as needed or desired. Here, the attachment of solder balls 170 may be provided by any process as may be known in the art for attaching solder balls to an exposed via or an exposed IC device back side, as needed or desired. Here, the solder balls that are attached to the back sides of IC device 140 and IC device 142 may provide a dual function of providing a clean ground plane to the bulk material of the IC devices, and of providing a thermally conductive path to remove heat from the IC devices, as needed or desired.

Note that other process steps may be provided in the context of the fabrication of flip chip device 100 as needed or desired. Further, the order of the steps is illustrative, and the illustrated process steps may be performed in a different order as needed or desired.

A flip chip device includes a substrate, an integrated circuit device, a mold compound, and a via. The substrate has a top side and a bottom side. The integrated circuit device is affixed to the bottom side of the substrate. The mold compound is affixed to the bottom side of the substrate. The via is affixed to the bottom side of the substrate. The via passes through the mold compound and is exposed at a bottom side of the mold compound. The via is coupled to a terminal of the integrated circuit device.

Although only a few exemplary embodiments have been described in detail herein, those skilled in the art will readily appreciate that many modifications are possible in the exemplary embodiments without materially departing from the novel teachings and advantages of the embodiments of the present disclosure. Accordingly, all such modifications are intended to be included within the scope of the embodiments of the present disclosure as defined in the following claims. In the claims, means-plus-function clauses are intended to cover the structures described herein as performing the recited function and not only structural equivalents, but also equivalent structures.

The above-disclosed subject matter is to be considered illustrative, and not restrictive, and the appended claims are intended to cover any and all such modifications, enhancements, and other embodiments that fall within the scope of the present invention. Thus, to the maximum extent allowed by law, the scope of the present invention is to be determined by the broadest permissible interpretation of the following claims and their equivalents, and shall not be restricted or limited by the foregoing detailed description.

## Claims

1. A flip chip device, comprising:
a substrate having a top side and a bottom side;
an integrated circuit device affixed to the bottom side of the substrate;
a mold compound applied to the bottom side of the substrate; and
a first via affixed to the bottom side of the substrate, wherein the first via passes through the mold compound and is exposed at a bottom side of the mold compound, and wherein the first via is coupled to a first terminal of the integrated circuit device.

2. The flip chip device of claim 1, further comprising:
a second via affixed to the bottom side of the substrate, wherein the second via passes through the mold compound and is exposed at the bottom side of the mold compound, and wherein the second via is coupled to a second terminal of the integrated circuit device.

3. The flip chip device of claim 2, wherein the first via is configured for carrying a radio frequency signal of the integrated circuit device.

4. The flip chip device of claim 3, wherein the second terminal is a shield terminal of the integrated circuit device.

5. The flip chip device of any of claims 2 to 4, wherein the second via forms a coaxial shield around the first via.

6. The flip chip device of any preceding claim, further comprising:
a first solder ball affixed to the first via at the bottom side of the mold compound.

7. The flip chip device of claim 6, further comprising:
a second solder ball affixed to a bottom side of the integrated circuit device.

8. The flip chip device of claim 7, wherein the second solder ball provides a ground terminal for the integrated circuit device.

9. The flip chip device of claim 7 or 8, wherein the second solder ball provides a thermal terminal for the integrated circuit device.

10. The flip chip device of any preceding claim, further comprising:
a passive device affixed to the bottom side of the substrate.

11. A method of fabricating a flip chip device, the method comprising:
attaching, to a bottom side of a substrate of the flip chip device, an integrated circuit device;
forming, on the bottom side of the substrate, a first via; and
applying, to the bottom side of the substrate, a mold compound;
wherein the first via passes through the mold compound and is exposed at a bottom side of the mold compound, and wherein the first via is coupled to a first terminal of the integrated circuit device.

12. The method of claim 11, further comprising:
prior to applying the mold compound, forming, on the bottom side of the substrate, a second, wherein the second via passes through the mold compound and is exposed at the bottom side of the mold compound, and wherein the second via is coupled to a second terminal of the integrated circuit device.

13. The method of claim 12, wherein the first via is configured for carrying a radio frequency signal of the integrated circuit device.

14. The method of claim 12 or 13, wherein the second terminal is a shield terminal of the integrated circuit device.

15. The method of any of claims 12 to 14, wherein the second via forms a coaxial shield around the first via.
